(19) Europäisches Patentamt
European Patent Office
Office européen des brevets

(11) **EP 3 272 010 B1**

(12) **FASCICULE DE BREVET EUROPEEN**

(45) Date de publication et mention
de la délivrance du brevet:
**26.12.2018   Bulletin 2018/52**

(51) Int Cl.:
*H01B 17/28* (2006.01)       *H01B 17/42* (2006.01)
*H01B 17/62* (2006.01)       *H01R 13/53* (2006.01)
*H02N 2/18* (2006.01)        *H03K 3/57* (2006.01)
*H03K 3/53* (2006.01)        *H03K 3/537* (2006.01)

(21) Numéro de dépôt: **16711563.3**

(22) Date de dépôt: **15.03.2016**

(86) Numéro de dépôt international:
**PCT/EP2016/055593**

(87) Numéro de publication internationale:
**WO 2016/146635 (22.09.2016 Gazette 2016/38)**

(54) **GENERATEUR D'IMPULSIONS DE HAUTE TENSION**

HOCHSPANNUNGSIMPULSGENERATOR

HIGH-VOLTAGE PULSE GENERATOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.03.2015   FR 1552131**

(43) Date de publication de la demande:
**24.01.2018   Bulletin 2018/04**

(73) Titulaire: **Commissariat à l'Énergie Atomique
et aux Énergies Alternatives
75015 Paris (FR)**

(72) Inventeur: **LASSALLE, Francis
46400 Saint-Jean Lespinasse (FR)**

(74) Mandataire: **Brevalex
95, rue d'Amsterdam
75378 Paris Cedex 8 (FR)**

(56) Documents cités:
**US-A- 4 367 412       US-A- 4 645 941
US-A- 5 621 255       US-B2- 7 989 987**

• **SHKARUBA M V ET AL: "ARKAD'EV-MARX
GENERATOR WITH CAPACITIVE COUPLING",
INSTRUMENTS AND EXPERIMENTAL
TECHNIQUES, CONSULTANTS BUREAU. NEW
YORK, US, vol. 3 part 2, no. 28, 1 mai 1985
(1985-05-01), pages 625-628, XP002080293, ISSN:
0020-4412**

## Description

## DOMAINE TECHNIQUE

La présente invention concerne la génération d'impulsions électriques de haute puissance, dites « hautes puissances pulsées ».

Elle concerne plus particulièrement un générateur de Marx.

## ÉTAT DE LA TECHNIQUE ANTÉRIEURE

De manière générale, un générateur de Marx est un circuit électrique destiné à produire une impulsion de haute tension.

Un générateur de Marx conventionnel comporte plusieurs étages qui sont chacun formés d'un condensateur de stockage d'énergie et d'un commutateur. Les condensateurs sont chargés en parallèle à une tension de charge puis ils sont déchargés en série au moyen des commutateurs, ce qui produit une impulsion de haute tension.

Durant la décharge, le générateur de Marx délivre son énergie à une charge qui peut être résistive, inductive, capacitive ou toute combinaison de ces trois propriétés. Dans la suite, on s'intéresse plus particulièrement au cas d'une charge résistive.

L'encombrement du générateur de Marx est lié à l'agencement et au dimensionnement de ses différents composants.

Le temps de montée de l'impulsion de décharge est globalement proportionnel au rapport de la somme de l'inductance du générateur de Marx et de l'inductance de la charge à la résistance de la charge. L'inductance et la résistance de la charge étant fixées, un point important pour l'optimisation du générateur de Marx est de minimiser son inductance.

L'inductance du générateur de Marx est liée à l'agencement et au dimensionnement des différents composants du générateur de Marx.

De nombreuses applications nécessitent de délivrer des impulsions présentant un front de montée le plus réduit possible, typiquement inférieur à 10 ns. La plupart des générateurs de Marx connus ne permettent pas d'atteindre cette performance sans l'utilisation d'un dispositif de raidissement de l'impulsion.

Un dispositif de raidissement connu est le dispositif dit « de peaking » qui associe un condensateur et un éclateur très haute tension, tous deux de faible inductance. Le rendement et la fiabilité d'un tel éclateur peuvent être des difficultés, surtout lorsqu'un fonctionnement en mode répétitif et une durée de vie importante, par exemple en nombres d'impulsions, sont recherchés.

En outre, un tel dispositif présente un encombrement qui augmente l'encombrement du générateur de Marx.

De manière plus précise, le commutateur d'un étage d'un générateur de Marx est soit un éclateur soit un commutateur à semi-conducteur. Dans la suite, on ne s'intéresse qu'au cas de l'éclateur. Un éclateur est formé de deux électrodes séparées par un fluide diélectrique, qui est généralement un gaz ou plus rarement un liquide. Cette isolation permet la charge du ou des condensateur(s) de l'étage du générateur de Marx. Pour la décharge, la fermeture de l'éclateur se traduit par la formation d'un arc électrique entre ces deux électrodes. Cette fermeture peut être provoquée par un auto-amorçage de l'arc ou déclenchée par un phénomène extérieur, tel qu'une surtension provenant d'un étage de Marx situé en amont, ou un phénomène électrique, optique ou plasma déclenché.

Généralement, les éclateurs fonctionnent sous gaz pressurisé et les dimensions de leurs électrodes sont grandes par rapport à celles du gap où se forme l'arc électrique. Pour supporter ces électrodes et contenir ce gaz pressurisé, la colonne d'éclateurs peut être logée dans une enveloppe diélectrique isolante. Le dimensionnement de cette colonne d'éclateurs et son positionnement par rapport à l'électrode de retour de courant ont un effet important sur l'inductance et donc sur les performances du système.

Pour contribuer à la réduction de la durée du front de montée de l'impulsion délivrée par le générateur de Marx, le séquençage de la fermeture des éclateurs est contrôlé.

Pour un fonctionnement sous gaz pressurisé, ce séquençage est amélioré si les éclateurs sont alignés sur un même axe. Cette configuration permet au rayonnement ultraviolet généré par l'arc à la fermeture d'un éclateur de provoquer la photo-ionisation de l'intervalle inter-électrodes de l'éclateur suivant. Ainsi le délai statistique de fermeture des éclateurs est réduit.

Un générateur de Marx est alimenté par un circuit de charge. Le circuit de charge comporte de manière générale une alimentation de puissance de tension basse relativement à la tension de sortie du générateur de Marx, un circuit de protection et un ensemble d'éléments distribués autour des étages pour permettre la charge des condensateurs de stockage d'énergie à partir de l'alimentation de puissance.

En outre, la tenue mécanique des différents composants et sous-systèmes tels que les supports d'étages et le circuit de charge par exemple, est assurée par des supports diélectriques. Sur les surfaces de ces isolants solides, les distances entre électrodes métalliques des différents composants, qui sont portées à des potentiels différents, doivent être suffisantes pour supporter sans claquage les tensions de fonctionnement.

L'impulsion délivrée est de forme dite double exponentielle ou amortie si chaque étage du générateur de Marx comporte un condensateur. Pour obtenir une impulsion plus longue, chaque condensateur du générateur de Marx est remplacé par une ligne de transmission. Dans une configuration dite PFN pour « Pulse Forming Network », un étage du générateur de Marx est formé par un réseau de plusieurs cellules (L,C), où L désigne une inductance et C désigne un condensateur.

Le document US 4367412 décrit un générateur d'impulsions de type Marx.

Le document US5621255 décrit la connexion entre les éclateurs et les capacités haute tension d'un générateur de Marx.

## EXPOSÉ DE L'INVENTION

L'invention vise à résoudre les problèmes de la technique antérieure en fournissant un générateur d'impulsions de haute tension comportant une pluralité d'étages et une électrode de retour de courant à la masse reliés en série, chacun des étages comportant au moins un élément de stockage d'énergie relié en série avec un éclateur, caractérisé en ce que

Les éclateurs sont répartis sur un axe,
Les éléments de stockage d'énergie de rang impair sont disposés d'un côté de l'axe des éclateurs, et
Les éléments de stockage d'énergie de rang pair sont disposés d'un autre côté de l'axe des éclateurs,
De sorte que le circuit formé par la pluralité d'étages et l'électrode de retour de courant présente une inductance réduite pendant une phase de décharge du générateur, par rapport à un générateur comportant les mêmes composants agencés selon une architecture conventionnelle, caractérisé en ce qu'un film diélectrique est disposé entre l'électrode de retour de courant et le circuit formé par la pluralité d'étages.

Cette configuration permet d'obtenir un front de montée des impulsions plus bref que selon la technique antérieure. En effet, cette configuration impose une circulation en zigzag du courant dans la ligne de transmission formée par les étages du générateur. Ainsi, les vecteurs d'induction magnétique sont de sens opposés d'un éclateur à son voisin. Le couplage entre deux vecteurs d'induction magnétique antagonistes est fort. Cela contribue à la réduction de l'inductance.

En outre, l'électrode de retour de courant est disposée au plus près possible des étages, ce qui contribue également à la réduction de l'inductance.

La réduction de l'inductance du générateur de Marx a pour effet de réduire la durée du front de montée de l'impulsion de décharge, sans avoir recours à un dispositif de raidissement d'impulsion autre que le générateur de Marx lui-même.

Cette configuration en zigzag permet également d'obtenir un générateur de Marx plus compact que selon la technique antérieure.

Selon une caractéristique préférée, la sortie d'un élément de stockage d'énergie amont, l'éclateur amont et l'entrée d'un élément de stockage d'énergie aval sont sensiblement alignés selon un axe sensiblement perpendiculaire à l'axe de la colonne d'éclateurs.

Cette configuration contribue à la limitation de l'encombrement du générateur de Marx.

Selon une caractéristique préférée, les électrodes des éclateurs sont directement reliées aux électrodes des éléments de stockage d'énergie.

Selon une caractéristique préférée, l'ensemble des composants du générateur est dans une enceinte métallique fermée qui contient un fluide diélectrique.

En variante, les éclateurs sont dans une enveloppe isolante contenant un fluide diélectrique.

Selon une caractéristique préférée, l'électrode de retour de courant est formée par l'enceinte métallique.

Selon une caractéristique préférée, l'électrode de retour de courant a une surface supérieure ou égale à la surface formée par le circuit de décharge formé par la pluralité d'étages.

Selon une caractéristique préférée, la distance entre l'électrode de retour de courant et un étage donné est croissante avec le rang de l'étage.

En variante, la distance entre l'électrode de retour de courant et le dernier étage est telle que l'impédance pour cet étage est égale à l'impédance de la charge.

Dans ce cas, le front de montée de l'impulsion est encore plus réduit.

Selon une caractéristique préférée, un élément de stockage d'énergie comporte un condensateur.

Selon une caractéristique préférée, un élément de stockage d'énergie comporte une cellule formée d'un condensateur et d'une inductance. Lorsque chaque étage comporte un réseau de cellules chacune formée d'un condensateur et d'une inductance, formant une ligne PFN, il est possible de générer des impulsions de type créneau, aussi bien en mode mono-coup qu'en mode répétitif.

## BRÈVE DESCRIPTION DES DESSINS

D'autres caractéristiques et avantages apparaîtront à la lecture de la description suivante d'un mode de réalisation préféré, donné à titre d'exemple non limitatif, décrit en référence aux figures dans lesquelles :

La figure 1 et la figure 2 représentent un générateur de Marx selon un premier mode de réalisation de l'invention,
Les figures 3a, 3b et 3c représentent respectivement une vue latérale, une vue de dessous et une vue de dessus d'un générateur de Marx selon un deuxième mode de réalisation de l'invention.

## EXPOSÉ DÉTAILLÉ DE MODES DE RÉALISATION PARTICULIERS

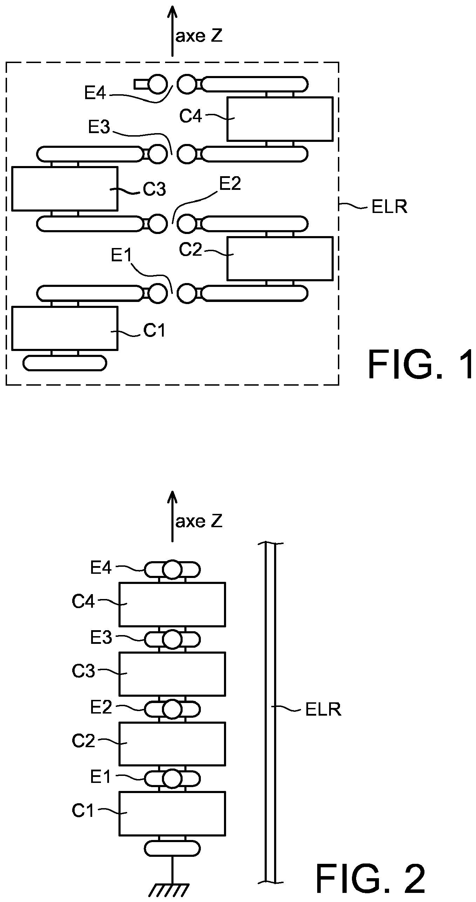

Selon un mode de réalisation préféré représenté à la **figure 1** et à la **figure 2,** un générateur de Marx comporte N étages, où N est égal à quatre à titre d'exemple. Bien entendu, le nombre d'étages peut être différent.

L'entrée du générateur est reliée à la masse. A partir de l'entrée, le générateur comporte un condensateur C1 dont l'électrode de sortie est reliée à l'électrode d'entrée d'un premier éclateur E1.

L'éclateur E1 a son électrode de sortie reliée à l'électrode d'entrée d'un second condensateur C2, et ainsi de suite pour les éclateurs E2, E3 et E4 et pour les condensateurs C3 et C4.

En variante, plusieurs condensateurs peuvent être connectés en parallèle sur un même étage pour réduire l'impédance et donc augmenter le courant délivré.

Il est à noter que les condensateurs utilisés sont des condensateurs céramiques ou tout autre type de condensateur.

Un circuit de charge classique, non représenté, alimente le générateur de Marx.

Dans cette configuration, la polarité de l'impulsion de sortie est de même signe que la polarité de la tension de charge des condensateurs.

En variante, les éléments sont agencés dans un ordre différent. A partir de l'entrée reliée à la masse, le générateur de Marx comporte un premier éclateur, relié en série avec un premier condensateur, lui-même relié en série avec un second éclateur, et ainsi de suite. La sortie du générateur de Marx est la sortie du dernier condensateur. Dans ce cas, la polarité de l'impulsion de sortie est de signe opposé à celui de la polarité de la tension de charge des condensateurs.

Comme on le voit à la figure 1, les N éclateurs sont répartis sur un axe Z et forment une colonne.

Les condensateurs de rang impair sont disposés d'un côté de l'axe des éclateurs, et les condensateurs de rang pair sont disposés d'un autre côté de l'axe des éclateurs.

En outre, la sortie d'un condensateur amont, l'éclateur amont et l'entrée d'un condensateur aval sont sensiblement alignés selon un axe sensiblement perpendiculaire à l'axe de la colonne d'éclateurs.

Les électrodes des éclateurs sont directement fixées aux électrodes des condensateurs. Aucun support isolant ni aucune enveloppe isolante ne sont utilisés pour la colonne d'éclateurs.

Les dimensions des électrodes des éclateurs sont miniaturisées de sorte que leur encombrement selon l'axe Z soit du même ordre de grandeur que l'encombrement des électrodes servant à la connexion des condensateurs. En pratique, cet encombrement peut être typiquement compris entre 5 et 15 mm.

Pour chaque éclateur, les deux électrodes en vis-à-vis peuvent être de géométrie sphérique, hémisphérique, plane ou de courbure définie pour obtenir une topologie de champ électrique spécifique entre électrodes.

Pour minimiser l'érosion due aux arcs électriques, le matériau des électrodes des éclateurs peut être un alliage tungstène-cuivre. Des électrodes métalliques avec un insert en alliage tungstène-cuivre localisé au voisinage de l'arc électrique peuvent également être utilisées.

Pour permettre le réglage de l'espace inter-électrodes, chaque électrode d'éclateur est vissée sur l'extrémité de l'électrode connectée au condensateur. Un système de freinage peut être prévu au niveau de cette liaison vissée pour éviter tout déréglage de l'espace inter-électrodes durant une salve d'impulsions.

Tous les composants, notamment les condensateurs et les éclateurs, mais aussi le circuit de charge non représenté, sont contenus dans une enceinte unique remplie d'un fluide diélectrique. Il peut s'agir d'un gaz pressurisé tel que de l'air sec ou du SF6 par exemple, ou d'un liquide. L'enceinte est de préférence cylindrique pour optimiser son dimensionnement tout en réduisant les efforts dus à la pression interne du gaz.

En variante, le milieu diélectrique utilisé pour l'isolation des éclateurs peut être différent de celui utilisé pour l'isolation des autres éléments du générateur de Marx. Dans ce cas, la colonne d'éclateur est logée dans une enveloppe isolante séparant ces deux milieux.

Le premier éclateur E1 est déclenché par un signal externe commandé. Les éclateurs suivants ne sont pas déclenchés par un signal externe. Ils sont fermés en avalanche, c'est-à-dire dans un ordre séquentiel suivant l'ordre des étages. En variante, le nombre d'éclateurs déclenchés par un signal extérieur peut être supérieur à un.

Pour un fonctionnement sous gaz pressurisé, le rayonnement ultraviolet sera de préférence non masqué selon l'axe Z. L'alignement des éclateurs selon l'axe Z permet au rayonnement ultraviolet généré par l'arc à la fermeture d'un éclateur de provoquer la photo-ionisation de l'intervalle inter-électrodes de l'éclateur suivant. Ainsi le délai statistique de fermeture des éclateurs est réduit et le séquençage est amélioré.

En variante, la distance inter-électrodes des éclateurs est réglée de façon à être croissante avec le rang des étages. Cela permet d'éviter un éventuel auto-amorçage trop précoce des éclateurs de rangs supérieurs.

Pour un fonctionnement en mode répétitif, c'est-à-dire avec des cycles de charge et de décharge récurrents, un mode de fonctionnement préféré comporte l'inhibition de la tension de charge entre deux cycles de charge consécutifs. Cette inhibition permet une meilleure extinction de l'arc électrique au niveau de chaque éclateur, ce qui permet d'obtenir un taux de répétitivité plus important.

Pour un fonctionnement en mode répétitif, il est également possible de réaliser au niveau de chaque éclateur un balayage forcé du gaz d'isolation. Ce flux gazeux permet une meilleure extinction de l'arc électrique ce qui permet d'obtenir un taux de répétitivité plus important.

La configuration en zigzag du générateur de Marx selon l'invention rend le générateur plus compact que selon la technique antérieure. En effet, si z est la longueur selon l'axe Z d'un condensateur muni de ses deux électrodes, la longueur selon l'axe Z du générateur de Marx selon la présente invention est légèrement inférieure à N.z. Le gain sur la longueur selon l'axe Z est compris entre 20 % et 60 % par rapport à un générateur conventionnel, dans lequel tous les condensateurs sont disposés selon une même colonne et séparée par une distance $z_i$ nécessaire pour une isolation inter-étage et/ou pour loger l'éclateur inter-étages. La longueur selon l'axe Z d'un générateur conventionnel est $N(z+z_i)$.

Cette configuration permet également de réduire le couplage capacitif parasite entre deux étages consécutifs, améliorant ainsi le séquençage de la fermeture des éclateurs et le comportement électrique global du générateur de Marx.

Cette configuration permet également de réduire le temps de montée de l'impulsion, en optimisant l'inductance $L_{MARX}$. L'inductance $L_{MARX}$ est formée par la boucle de courant qui circule dans les N étages du générateur de Marx et qui retourne vers la masse, via une électrode ELR, dite électrode de retour de courant.

En effet, le temps de montée de l'impulsion est globalement proportionnel à L/R, où L est l'inductance résultant de la somme de l'inductance du générateur $L_{MARX}$ et de l'inductance de la charge $L_{Charge}$, et R est la résistance de la charge.

Pour une charge donnée, les paramètres R et $L_{Charge}$ sont fixés. On cherche donc à minimiser l'inductance $L_{MARX}$ pour réduire la durée du front de montée de l'impulsion.

Lorsque les N étages sont mis en série par la fermeture des N éclateurs, le courant circule successivement, pour n variant de 1 à N, dans le condensateur Cn, dans une électrode de connexion, dans l'éclateur En puis dans une seconde électrode de connexion.

L'électrode de retour de courant ELR est généralement formée par l'enceinte métallique dans laquelle est logé le générateur de Marx. En variante, l'électrode de retour de courant ELR peut être un composant spécifique dont la géométrie et la position sont choisies pour optimiser la boucle de courant formée lors de la décharge du générateur de Marx.

La distance entre l'électrode de retour de courant ELR et le circuit formé par les N étages du générateur influe sur l'inductance $L_{MARX}$. Cette distance est réduite autant que possible, et la surface de l'électrode de retour de courant ELR est égale ou supérieure à la surface du circuit de décharge formé par les N étages, c'est-à-dire la surface équivalente formée par les électrodes, condensateurs et éclateurs dans lesquels circule le courant. Cependant, la distance entre l'électrode de retour de courant ELR et les N étages doit être suffisante pour assurer l'isolation électrique du système pendant ses différentes phases de fonctionnement, notamment la charge et la décharge. Cette distance d'isolation dépend d'un certain nombre de paramètres, tels que par exemple la nature et la pression du gaz diélectrique, ou la nature du liquide diélectrique, ou les champs électriques liés aux géométries des composants et des électrodes.

En variante, un film diélectrique peut être placé contre l'électrode de retour de courant ELR pour réduire la distance d'isolation entre cette électrode et les N étages du générateur.

L'inductance $L_{MARX}$ de la boucle de courant est calculée en utilisant l'expression du flux $\phi$ :

$$\Phi = L_{MARX} I = \vec{B}.d\vec{S}$$

Dans laquelle $I$ est le courant, $\vec{B}$ est le vecteur d'induction magnétique et $d\vec{S}$ est le vecteur de surface.

L'inductance $L_{MARX}$ dépend donc du vecteur d'induction magnétique, du vecteur de surface et du courant : $L_{MARX} = \vec{B}.d\vec{S}/I$.

Dans le générateur de Marx selon l'invention, le courant de décharge circule en zigzag dans les N étages, lorsque les éclateurs sont fermés.

Dans les éclateurs, le courant circule selon un axe perpendiculaire à l'axe Z, soit un axe horizontal dans la figure 1. Le sens du courant dans un éclateur est opposé au sens du courant dans un éclateur voisin. Les vecteurs d'induction magnétique induits respectivement par le passage du courant dans un éclateur et dans un éclateur voisin sont donc de sens opposés, selon l'axe Z.

Compte tenu de leur proximité, le couplage entre ces deux vecteurs d'induction magnétique antagonistes est fort. L'induction magnétique au niveau de chaque éclateur est donc fortement diminuée. En conséquence, l'inductance de chaque éclateur est elle aussi fortement diminuée.

Il en est de même pour les électrodes qui relient les éclateurs aux condensateurs. En conséquence, l'inductance de ces électrodes est elle aussi fortement diminuée.

Selon cette invention, la circulation en zigzag du courant de décharge dans les N étages est donc à l'origine de la diminution de l'inductance $L_{MARX}$ et permet de réduire le temps de montée de l'impulsion.

En variante, la distance d'isolation entre un étage et l'électrode de retour de courant ELR est adaptée au niveau de tension subi par l'étage en question. Ainsi, la distance d'isolation est croissante depuis l'étage de rang 1 qui se trouve au voisinage de la masse jusqu'à l'étage de rang N, qui est porté à une tension impulsionnelle égale à la tension de sortie du générateur de Marx.

La ligne de transmission formée par le circuit des N étages et par l'électrode de retour de courant ELR présente alors une impédance croissante avec le rang n.

En variante, la géométrie de la ligne de transmission formée par le circuit des N étages et par l'électrode de retour de courant ELR est adaptée pour que son impédance soit croissante en fonction du rang n et atteigne au niveau du rang N une valeur égale à l'impédance de la charge. On obtient alors un régime de décharge similaire à la décharge théorique d'une ligne sur une charge adaptée. Le front de montée de l'impulsion délivrée a alors une durée encore plus réduite.

A titre d'exemple, il est possible d'obtenir des fronts de montée de durée inférieure à 10 ns, sans utilisation d'un dispositif « de peaking ».

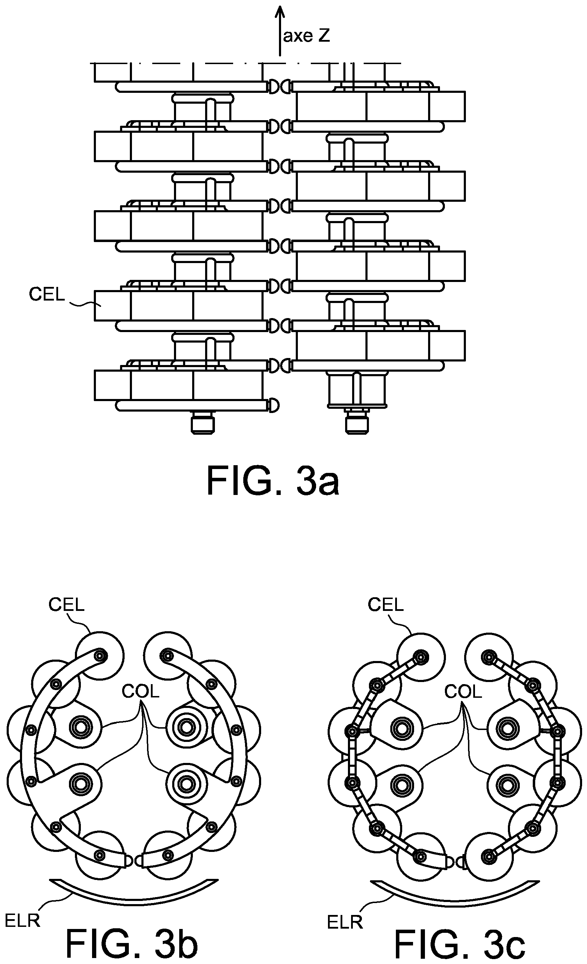

En référence aux **figures 3a, 3b et 3c,** un générateur de Marx selon un deuxième mode de réalisation de l'invention est destiné à délivrer une impulsion créneau, ou plateau ou encore rectangle. Les figures 3a, 3b et 3c représentent respectivement le générateur de Marx vu de côté, de dessous et de dessus.

Pour obtenir une impulsion créneau, chaque étage du premier mode de réalisation est modifié pour remplacer le condensateur par un réseau de cellules (L, C). A titre d'exemple, le nombre d'étages peut être compris entre 5 et 20, et le nombre de cellules d'un étage peut être compris entre 4 et 10. A cette exception près, toutes les caractéristiques exposées en relation avec le premier mode de réalisation se retrouvent dans le second mode de réalisation.

Le réseau de cellules (L,C) d'un étage donné comporte S cellules CEL reliées en série. Chaque cellule comporte un condensateur de capacité C et une inductance de valeur L. Ce réseau, également nommé ligne PFN, permet d'obtenir une décharge de type créneau au niveau de chaque étage. L'amplitude de ce créneau est multipliée lorsque les N étages sont mis en série par la fermeture quasi-instantanée des éclateurs.

La ligne de cellules peut être une ligne droite par exemple, ou une ligne courbe comme représenté aux figures 3a, 3b et 3c, de manière à épouser la géométrie cylindrique de l'enceinte.

Comme dans le premier mode de réalisation, les éclateurs sont répartis sur l'axe Z, les étages sont alternativement disposés de part et d'autre de l'axe Z et l'électrode de retour de courant ELR peut être l'enceinte métallique du générateur de Marx.

La durée $T_p$ de l'impulsion créneau est approximée par la formule :

$$T_p = 2.S.\sqrt{LC}$$

L'impédance Z de chaque étage est approximée par la formule :

$$Z = \sqrt{L/C}$$

Après fermeture des N éclateurs, l'impédance $Z_N$ du générateur de Marx est approximée par la formule :

$$Z_N = N.\sqrt{L/C}$$

La durée Tp de l'impulsion créneau peut être adaptée en modifiant de façon indépendante ou combinée le nombre de cellules S, la valeur de l'inductance L et la valeur de capacité C de chaque condensateur.

En variante, les cellules (L,C) présentent une valeur d'inductance différente et/ou une valeur de capacité différente afin de modifier le profil de l'impulsion délivrée. Ces différences peuvent être apportées au sein d'un même étage et/ou d'un étage à l'autre.

Il est à noter qu'après la fermeture des N éclateurs, le circuit de décharge ne fait intervenir que le premier des S condensateurs de chaque ligne PFN. Le premier condensateur est le condensateur le plus proche de l'éclateur.

L'optimisation du front de montée est donc similaire à ce qui a été décrit précédemment.

Pour chaque étage, la ligne PFN comporte les S condensateurs avec leur électrode d'entrée respective reliée en ligne sur une même électrode, dite électrode d'entrée de la ligne PFN. Les électrodes de sortie de deux condensateurs adjacents sont reliées via une inductance de valeur L.

En variante, les électrodes d'entrée de deux condensateurs adjacents sont également reliées via une inductance de valeur L. Dans ce cas, l'inductance équivalente de chaque cellule (L,C) présente une valeur 2.L.

Les condensateurs sont par exemple des condensateurs de type céramique de géométrie cylindrique. Ces condensateurs peuvent présenter pendant leur fonctionnement un effet piézo-électrique qui se traduit par un léger déplacement de leurs électrodes. L'assemblage condensateur/inductance doit donc présenter un degré de souplesse pour qu'au moins une des électrodes ne soit pas contrainte mécaniquement sous l'effet de ce déplacement. Ainsi le risque d'endommagement et de vieillissement prématuré des condensateurs est réduit.

Différents types d'inductance sont utilisables, par exemple inductance spiralée sur noyau ferromagnétique, inductance spiralée, inductance filaire courbe, inductance filaire linéaire, ou inductance de type ligne plate.

Ces types sont classés par valeur d'inductance décroissante.

Par exemple, pour former une inductance de type ligne plate, l'électrode respective des S condensateurs est reliée sur une électrode unique, l'électrode respective de sortie des S condensateurs est également reliée sur une autre électrode unique. L'inductance est alors définie par le volume magnétisé délimité par le contour entre deux condensateurs adjacents et par ces deux électrodes.

En variante, chaque ligne PFN peut être formée par une ligne de transmission de type ligne plate ou de type ligne coaxiale. Une ligne de transmission de type ligne plate comporte deux électrodes séparées par un matériau diélectrique, sans confinement du champ magnétique entre les deux électrodes. Une ligne de transmission de type ligne coaxiale comporte deux électrodes séparées par un matériau diélectrique, avec confinement du champ magnétique entre les deux électrodes.

En variante, plusieurs lignes de transmission peuvent être connectées en parallèle sur un même étage pour réduire l'impédance et augmenter le courant délivré.

Le circuit de charge du générateur de Marx comporte un ensemble d'éléments qui sont soit des résistances soit des inductances. Ces éléments sont distribués autour des étages.

Dans le cas d'un fonctionnement en mode répétitif, l'utilisation d'inductances permet de minimiser les pertes pendant la charge des condensateurs.

Selon le mode de réalisation préféré représenté aux figures 3a, 3b et 3c, le circuit de charge comporte quatre colonnes d'inductance COL. Une colonne d'inductance est reliée à l'électrode d'entrée des condensateurs de rang impair, une colonne d'inductance est reliée à l'électrode de sortie des condensateurs de rang impair, une colonne d'inductance est reliée à l'électrode d'entrée des condensateurs de rang pair et une colonne d'inductance est reliée à l'électrode de sortie des condensateurs de rang pair.

Sur une même colonne, les inductances sont des éléments creux et rigides, enfilés et superposés sur une tige isolante unique dont la longueur est adaptée à la longueur du générateur de Marx selon l'axe Z. Chaque tige isolante est un élément rigide ancré sur un élément solidaire du générateur de Marx, au niveau de la base des N étages.

Pour chacune des colonnes de condensateur de rang pair et impair, au moins une électrode, d'entrée ou de sortie, est reliée par une liaison rigide à une inductance de charge.

L'assemblage de tiges isolantes, colonnes d'inductances et colonnes de condensateurs fournit une structure rigide pour l'ensemble des N étages et permet un positionnement précis de chaque composant au sein du générateur de Marx. Il s'agit donc d'une structure autoportée qui ne nécessite pas de support ou de dispositif isolant supplémentaire.

Cette structure autoportée minimise les surfaces d'isolants solides soumis à des différences de potentiels et qui sont des zones de fragilité potentielles en ce qui concerne les pertes et les risques de claquages électriques. Il est à noter que seules les surfaces des tiges isolantes sont soumises à la tension maximale qui est la tension de sortie du générateur lors de sa décharge. Les risques de perte ou de claquages électriques sont donc réduits compte tenu de la grande longueur des tiges isolantes. Cette structure améliore donc la fiabilité et la durée de vie du générateur de Marx.

Cette structure autoportée contribue à la compacité et à la simplicité mécanique du générateur de Marx. Elle facilite les opérations de montage et démontage ainsi que les opérations de maintenance.

Elle permet en outre de minimiser les vibrations induites par la fermeture des éclateurs durant une salve d'impulsions, ce qui améliore la fiabilité de fonctionnement.

Enfin, elle autorise le système à subir des accélérations et/ou des vibrations ce qui facilite son transport et sa manutention. Un fonctionnement sur système embarqué, soumis à accélération et/ou vibrations est possible.

Au niveau de ces liaisons rigides, les électrodes peuvent être fendues afin de bloquer la circulation des courants de Foucault induits dans les électrodes par les inductances du circuit de charge. Cette configuration permet, pendant la décharge du générateur de Marx, d'optimiser le découplage inductif entre étages apporté par les colonnes d'inductances.

En variante, le circuit de charge comporte des résistances à la place des inductances.

Bien entendu, la structure autoportée décrite s'applique aussi bien à un générateur de Marx comportant un condensateur par étage qu'une ligne de cellules (L,C) par étage.

La sortie du générateur de Marx est connectée à la charge, soit directement, soit par l'intermédiaire d'une connectique spécifique. De préférence, cette liaison est réalisée par une ligne de transmission dont l'impédance est adaptée à celle de la charge. Ainsi la durée du front de montée de l'impulsion n'est pas augmentée par cette inductance.

La ligne de transmission entre le générateur de Marx et la charge est de préférence de structure coaxiale. L'isolation de la ligne de transmission est assurée par le même gaz sous pression ou le même liquide diélectrique que celui utilisé pour l'isolation du générateur de Marx. Aucun support ou interface isolant solide n'est utilisé en sortie du générateur ni au sein de la ligne de transmission. La liaison est donc compacte, simple et fiable.

En variante, la ligne de transmission entre le générateur de Marx et la charge est un câble coaxial haute tension dont l'impédance est adaptée à celle de la charge.

Grâce à cette adaptation d'impédance, la longueur et la forme de la ligne de transmission ont peu ou pas d'influence sur les caractéristiques des impulsions délivrées par le générateur de Marx à la charge. Il est ainsi possible de déporter la charge à distance du générateur et/ou de positionner l'axe de la charge dans un axe différent de celui du générateur de Marx.

Liste de brevets relatifs aux générateurs de Marx :

- US 20122001498

- EP 1 760 884

- US 7989987

- US 6060791

- US 5621255

- US 4900947

- US 3909624

- US 3863105

- DE 455 933

**Revendications**

1. Générateur d'impulsions de haute tension comportant une pluralité d'étages et une électrode de retour de courant à la masse reliés en série, chacun des étages comportant au moins un élément de stockage d'énergie (C1, C2, C3, C4, CEL) relié en série avec un éclateur (E1, E2, E3, E4), dans lequel
Les éclateurs sont répartis sur un axe (Z),
Les éléments de stockage d'énergie de rang impair (C1, C3) sont disposés d'un côté de l'axe des éclateurs, et
Les éléments de stockage d'énergie de rang pair (C2, C4) sont disposés d'un autre côté de l'axe des éclateurs,
De sorte que le circuit formé par la pluralité d'étages et l'électrode de retour de courant présente une inductance réduite pendant une phase de décharge du générateur, par rapport à un générateur comportant les mêmes composants agencés selon une architecture conventionnelle, **caractérisé en ce qu'**un film diélectrique est disposé entre l'électrode de retour de courant (ELR) et le circuit formé par la pluralité d'étages.

2. Générateur d'impulsions de haute tension selon la revendication 1, **caractérisé en ce que** la sortie d'un élément de stockage d'énergie amont, l'éclateur amont et l'entrée d'un élément de stockage d'énergie aval sont sensiblement alignés, selon un axe sensiblement perpendiculaire à l'axe de la colonne d'éclateurs.

3. Générateur d'impulsions de haute tension selon la revendication 1, **caractérisé en ce que** les électrodes des éclateurs sont directement reliées aux électrodes des éléments de stockage d'énergie.

4. Générateur d'impulsions de haute tension selon l'une quelconque des revendications 1 à 3, **caractérisé en ce que** l'ensemble des composants du générateur est dans une enceinte métallique fermée qui contient un fluide diélectrique.

5. Générateur d'impulsions de haute tension selon la revendication 4, **caractérisé en ce que** l'électrode de retour de courant (ELR) est formée par l'enceinte métallique.

6. Générateur d'impulsions de haute tension selon l'une quelconque des revendications 1 à 5, **caractérisé en ce que** l'électrode de retour de courant (ELR) a une surface supérieure ou égale à la surface formée par le circuit de décharge formé par la pluralité d'étages.

7. Générateur d'impulsions de haute tension selon l'une quelconque des revendications 1 à 6, **caractérisé en ce que** la distance entre l'électrode de retour de courant (ELR) et un étage donné est croissante avec le rang de l'étage.

8. Générateur d'impulsions de haute tension selon la revendication 7, **caractérisé en ce que** la distance entre l'électrode de retour de courant (ELR) et le dernier étage est tel que l'impédance pout cet étage est égale à l'impédance de la charge.

9. Générateur d'impulsions de haute tension selon l'une quelconque des revendications 1 à 8, **caractérisé en ce qu'**un élément de stockage d'énergie comporte un condensateur (C1, C2, C3, C4).

10. Générateur d'impulsions de haute tension selon l'une quelconque des revendications 1 à 9, **caractérisé en ce qu'**un élément de stockage d'énergie comporte une cellule (CEL) formée d'un condensateur et d'une inductance.

**Patentansprüche**

1. Hochspannungsimpulsgenerator, enthaltend eine Mehrzahl von Stufen und eine geerdete Stromrückkopplungselektrode, die in Reihe geschaltet sind, wobei jede der Stufen zumindest ein Energiespeicherelement (C1, C2, C3, C4, CEL) aufweist, das mit einer Funkenstrecke (E1, E2, E3, E4) in Reihe geschaltet ist, wobei
die Funkenstrecken über eine Achse (Z) verteilt sind, die Energiespeicherelemente mit ungeradem Rang (C1, C3) auf einer Seite der Achse der Funkenstrecken angeordnet sind, und
die Energiespeicherelemente mit geradem Rang (C2, C4) auf der anderen Seite der Achse der Funkenstrecken angeordnet sind,
so dass die aus der Mehrzahl von Stufen und aus der Stromrückkopplungselektrode gebildete Schaltung während einer Entladungsphase des Generators eine reduzierte Induktivität aufweist, verglichen mit einem Generator, der die gleichen Komponenten umfasst, die gemäß einer herkömmlichen Architektur angeordnet sind,
**dadurch gekennzeichnet, dass** ein dielektrischer Film zwischen der Stromrückkopplungselektrode (ELR) und der aus der Mehrzahl von Stufen gebildeten Schaltung angeordnet ist.

2. Hochspannungsimpulsgenerator nach Anspruch 1, **dadurch gekennzeichnet, dass** der Ausgang eines vorgeschalteten Energiespeicherelements, die vorgeschaltete Funkenstrecke und der Eingang eines nachgeschalteten Energiespeicherelements im Wesentlichen entlang einer Achse ausgerichtet sind, die im Wesentlichen senkrecht zur Achse der Funkenstreckensäule verläuft.

**3.** Hochspannungsimpulsgenerator nach Anspruch 1, **dadurch gekennzeichnet, dass** die Elektroden der Funkenstrecken direkt mit den Elektroden der Energiespeicherelemente verbunden sind.

**4.** Hochspannungsimpulsgenerator nach einem der Ansprüche 1 bis 3, **dadurch gekennzeichnet, dass** die gesamten Komponenten des Generators in einem geschlossenen Metallgehäuse liegen, das ein dielektrisches Fluid enthält.

**5.** Hochspannungsimpulsgenerator nach Anspruch 4, **dadurch gekennzeichnet, dass** die Stromrückkopplungselektrode (ELR) aus einem Metallgehäuse gebildet ist.

**6.** Hochspannungsimpulsgenerator nach einem der Ansprüche 1 bis 5, **dadurch gekennzeichnet, dass** die Stromrückkopplungselektrode (ELR) eine Oberfläche größer oder gleich der Oberflache hat, die von der Entladungsschaltung aus der Mehrzahl von Stufen gebildet wird.

**7.** Hochspannungsimpulsgenerator nach einem der Ansprüche 1 bis 6, **dadurch gekennzeichnet, dass** die Entfernung zwischen der Stromrückkopplungselektrode (ELR) und einer gegebenen Stufe mit dem Rang der Stufe zunimmt.

**8.** Hochspannungsimpulsgenerator nach Anspruch 7, **dadurch gekennzeichnet, dass** die Entfernung zwischen der Stromrückkopplungselektrode (ELR) und der letzten Stufe derart ist, dass die Impedanz bei dieser Stufe gleich der Impedanz der Last ist.

**9.** Hochspannungsimpulsgenerator nach einem der Ansprüche 1 bis 8, **dadurch gekennzeichnet, dass** ein Energiespeicherelement einen Kondensator (C1, C2, C3, C4) enthält.

**10.** Hochspannungsimpulsgenerator nach einem der Ansprüche 1 bis 9, **dadurch gekennzeichnet, dass** ein Energiespeicherelement eine Zelle (CEL) enthält, die aus einem Kondensator und einer Induktivität gebildet ist.

**Claims**

**1.** High-voltage pulse generator comprising a plurality of stages and a current return electrode to the earth connected in series, with each one of the stages comprising at least one energy storage element (C1, C2, C3, C4, CEL) connected in series with a spark gap (E1, E2, E3, E4), wherein
The spark gaps are distributed on an axis (Z),
The odd-numbered energy storage elements (C1, C3) are arranged on one side of the spark gap axis, and
The even-numbered energy storage elements (C2, C4) are arranged on the other side of the spark gap axis,
In such a way that the circuit formed by the plurality of stages and the current return electrode has a reduced inductance during a discharge phase of the generator, with respect to a generator comprising the same components arranged along a conventional architecture,
**characterised in that** a dielectric film is arranged between the current return electrode (ELR) and the circuit formed by the plurality of stages.

**2.** High-voltage pulse generator according to claim 1, **characterised in that** the output of an upstream energy storage element, the upstream spark gap and the input of a downstream energy storage element are substantially aligned, along an axis that is substantially perpendicular to the axis of the column of spark gaps.

**3.** High-voltage pulse generator according to claim 1, **characterised in that** the electrodes of the spark gaps are directly connected to the electrodes of the energy storage elements.

**4.** High-voltage pulse generator according to any of claims 1 to 3, **characterised in that** all of the components of the generator are in a closed metal enclosure that contains a dielectric fluid.

**5.** High-voltage pulse generator according to claim 4, **characterised in that** the current return electrode (ELR) is formed by the metal enclosure.

**6.** High-voltage pulse generator according to any of claims 1 to 5, **characterised in that** the current return electrode (ELR) has a surface greater than or equal to the surface formed by the discharging circuit formed by the plurality of stages.

**7.** High-voltage pulse generator according to any of claims 1 to 6, **characterised in that** the distance between the current return electrode (ELR) and a given stage increases with the rank of the stage.

**8.** High-voltage pulse generator according to claim 7, **characterised in that** the distance between the current return electrode (ELR) and the last stage is such that the impedance for this stage is equal to the impedance of the charge.

**9.** High-voltage pulse generator according to any of claims 1 to 8, **characterised in that** an energy storage element comprises a capacitor (C1, C2, C3, C4).

10. High-voltage pulse generator according to any of claims 1 to 9, **characterised in that** an energy storage element comprises a cell (CEL) formed from a capacitor and from an inductance.

FIG. 1

FIG. 2

axe Z

CEL

## FIG. 3a

CEL

COL

ELR

## FIG. 3b

CEL

COL

ELR

## FIG. 3c

**EP 3 272 010 B1**

**RÉFÉRENCES CITÉES DANS LA DESCRIPTION**

**Documents brevets cités dans la description**

- US 4367412 A
- US 5621255 A
- US 20122001498 A
- EP 1760884 A
- US 7989987 B
- US 6060791 A
- US 4900947 A
- US 3909624 A
- US 3863105 A
- DE 455933